# EUROPEAN PATENT APPLICATION

(11) **EP 0 765 010 A2**
(43) Date of publication of application: **26.03.1997**
(21) Application number: 96114715.4
(22) Date of filing: 13.09.1996
(51) Int. Cl.: H01R 23/72

(54) **Anti-wicking board to board connector**

(30) Priority: 14.09.1995 JP 10722/95
(71) Applicant: MOLEX INCORPORATED, Lisle Illinois 60532 (US)
(72) Inventor: Yagi, Masanori, Ebina-shi, Kanagawa (JP)
(74) Representative: Blumbach, Kramer & Partner

(57) **Abstract**

A connector (100) is provided with anti-wicking capabilities which substantially prevents the contamination of interior contact portions (4,4') of the connector terminals (2,2') by solder and flux wicking up along the terminals through openings (106,106') in the housing of the connector (100). A surface interruption (8,8') such as a groove or ridge (8,8') is provided in the terminal connecting portions (6,6') which provides a tortuous path between the solder tail (7,7') and contact portions (4,4') of the terminal (2,2').

## Description

### Background of the Invention

The present invention generally relates to electrical connectors used for mounting on printed circuit boards and, more particularly, to an improved board to board connector which prevents the wicking of solder or flux into the connector during the process of soldering the connector onto a circuit board.

Conventional electrical connectors which are mounted on printed circuit boards typically have an insulative housing and a plurality of conductive terminals arranged within the housing at predetermined positions or pitch. Each conductive terminal has a base portion which extends through the housing near its bottom to project externally to form a solder tail. Each solder tail of the connector may be rigidly fixed on a conductive circuit trace printed on a circuit board by soldering the tails to the printed circuit board. This soldering is typically accomplished by aligning the connector solder tails with circuit board traces which have previously had a layer of a combination of solder paste and solder flux applied thereto. The aligned assembly is passed through an appropriate heating means, such as an infrared oven, to melt the solder on the circuit board traces to form a connection between the connector solder tails and the circuit board.

In these conventional connectors, the molten solder and/or solder flux has, at times, a tendency to flow, or "wick," up along the terminal and possibly through minute gaps in the portions of the housing through which the terminals extend. As a result of this wicking, the contact portions of the terminals within the connector housing may become contaminated by the wicking solder and/or solder flux and the performance and quality of the connector is decreased.

The present invention is therefore directed to an improved connector with anti-solder wicking capabilities.

### Summary of the Invention

In one principal aspect of the present invention an electrical connector is provided with an insulative housing and a plurality of conductive terminals arranged at predetermined spacings within the housing. Each of the terminals have a solder tail extending outwardly through the housing and a contact portion, the solder tail being integrally formed with the contact portion and joined thereto by way of a connecting portion. A surface irregularity or unevenness is formed on the connecting portion which may engage a complementary shaped unevenness formed in the housing to thereby provide an interruption in a torturous path extending along the surface of the connecting portion from the solder tail to the contact portion which prevents molten solder and/or solder flux from wicking up the terminal to the contact portion. The surface interruptions of the terminal may be formed around substantially the entire circumference of the connecting portion or they may be formed on only one side of the connecting portion.

In another aspect of the present invention and as exemplified by a preferred embodiment, the surface interruption of the conductive terminal may take the form of a groove formed in the surface of the connecting portion of the conductive terminal. In another embodiment, the surface interruptions of the terminal may take the form of one or more ridges formed on the surface of the connecting portion which is continuous with the contact portion of the terminal.

In still another principal aspect of the present invention and as exemplified by another embodiment, a connector has a housing containing a plurality of terminals arranged within the housing at a given pitch, each terminal having a contact portion disposed within a connector slot formed in the housing, a solder tail portion extending outwardly from the housing and an intermediate connecting portion interconnecting the solder tail and contact portions, the connecting portion including a surface irregularity and the housing containing a like irregularity or projection complementary in configuration to that of the terminal connecting portion irregularity such that the two irregularities engage each other.

It is therefore an object of the present invention to provide an electrical connector which reduces or substantially eliminates the possibility of wicking of molten solder or solder flux up from the terminal solder tail portion to the terminal contact portion when soldering the connector onto a printed circuit board.

Another object of the present invention to provide an improved board to board connector with anti-wicking capabilities which will substantially prevent the "wicking" of molten solder and/or solder flux from the connector solder tail portions into the connector housing and onto the contact portions of the terminals.

These and other objects, features and advantages of the present invention will be clearly understood through a consideration of the following detailed description.

### Brief Description of the Drawings

In the course of the following description of the detailed description, reference will be made to the attached drawings wherein like reference numerals identify like parts and wherein:

FIG. 1 is a sectional view of one embodiment of an electrical connector constructed in accordance with the principles of the present invention taken along line 1-1 of FIG. 3.

FIG. 2 is an enlarged perspective view of a terminal member used in the electrical connector of FIG. 1.

FIG. 3 is a perspective view of an electrical connector utilizing the terminal members of FIG. 2.

FIG. 4 is a sectional view of a second embodiment of an electrical connector constructed in accordance with the principles of the present invention; and

FIG. 5 is an enlarged perspective view of a terminal member used in the electrical connector of FIG. 4.

### Description of Preferred Embodiments

The present invention will be discussed hereinafter in detail in terms of the preferred embodiments as applied to an electrical connector that may be produced by insert molding.

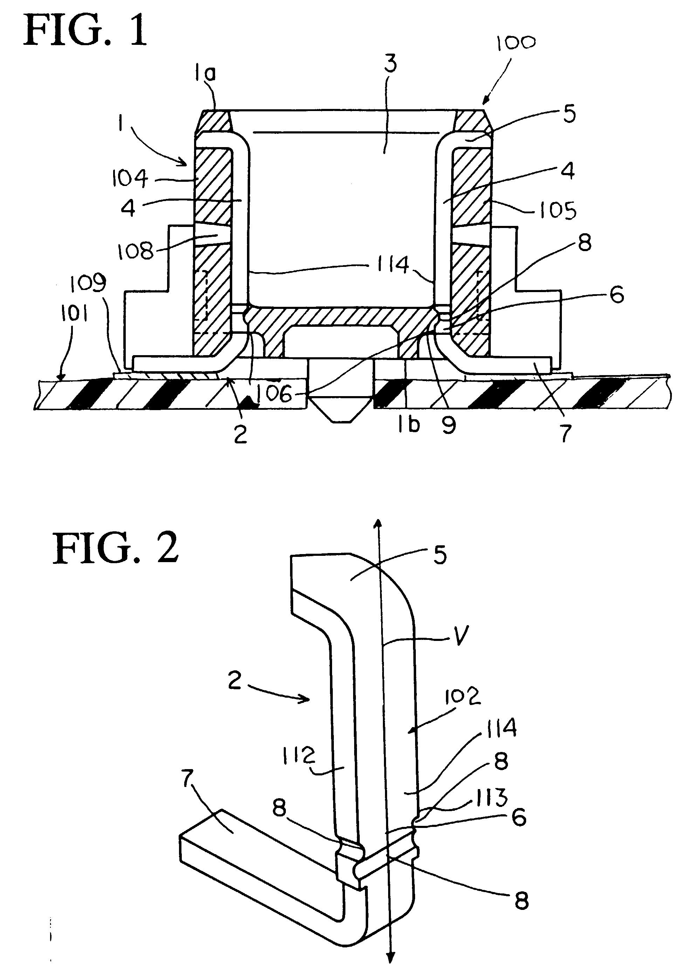

FIGS. 1 to 3 illustrate a first embodiment of an electrical connector 100 constructed in accordance with the principles of the present invention. The connector 100 includes an elongated housing 1 formed from an insulative plastic material and having a plurality of conductive terminals 2. The conductive terminals 2 are disposed along an elongated slot 3 and arranged in respective pairs of opposing terminals 2 on opposite sides of the slot 3. These terminals 2 are fixed within the connector housing 1 at a predetermined pitch, which is the centerline spacing of the terminals along the longitudinal axis L of the connector housing 1.

The connector illustrated in the Figures is a female connector component which mates with an opposing male connector component, commonly known in the art as a "plug" connector. Such a plug connector has a central plug portion, which extends up from its base and is received within the engagement slot 3 of the housing 1 illustrated. Both connector components are affixed to printed circuit boards 101 in the manner illustrated. Although this detailed description is set forth in terms of the female connector 100 illustrated, such a description is merely exemplary and it will be understood that the Figures are not to be construed as limiting in nature, but that the present invention may be suitably used and applied with plug and other style connectors.

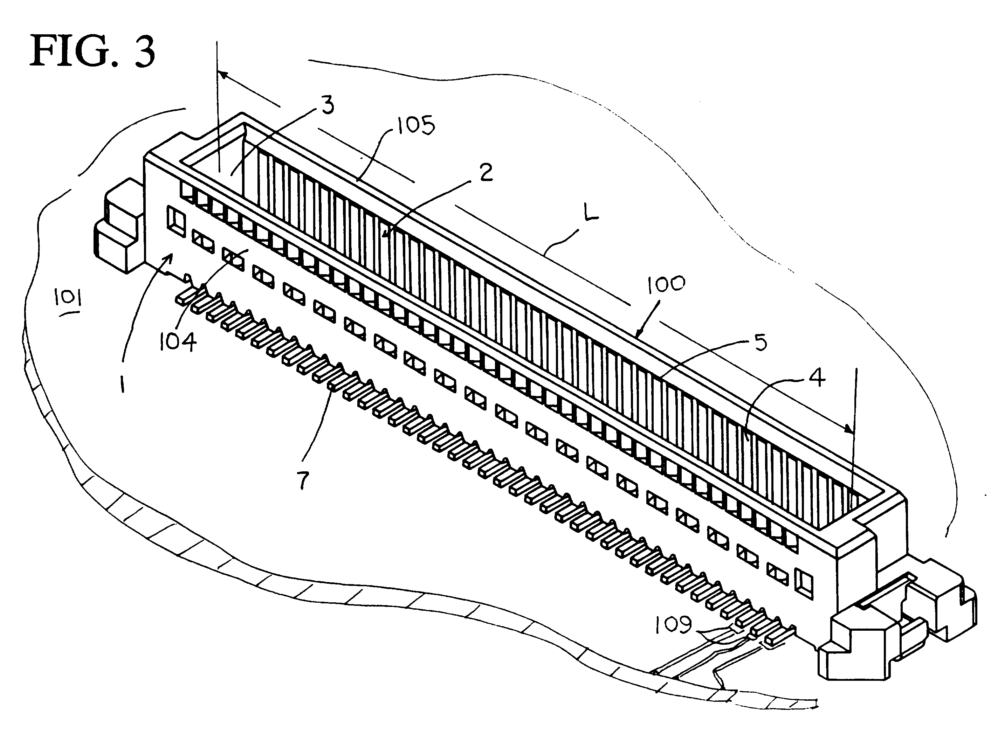

Turning now to FIGS. 2 and 3, it can be seen that each terminal 2 includes a terminal body portion 102 having a number of distinct portions. One end of each terminal 2 includes an engagement arm 5 which extends outwardly from the terminal body portions 102 and is received within the connector housing sidewalls 104, 105. Likewise, a solder tail 7 extends outwardly from the terminal body portion 102 at the other end, and both of the solder tails 7 and engagement arms 5 are oriented perpendicular to the terminal body portion 102. As seen in FIG. 1, the engagement arms 5 of the terminals 2 are encased within the housing sidewalls 104, 105 as a result of an insert molding process and the solder tails 7 extend out from the housing through the bottom 1b of the housing 1 through associated openings 106 formed in the housing bottom 1b.

In the manufacture of such connectors, the terminals 2 are commonly held within a mold at their predetermined pitch by an appropriate means, such as molding pins, which normally extend through the sides of the mold, and plastic is injected into the mold around the terminals 2. The areas at which the terminals 2 are held by these pins define openings 108 in the housing sidewalls 104, 105 when the housing 1 is released from the mold, which expose a portion of each terminal for continuity testing. Such molding process is more specifically described in European Patent Publication No. EP 693802, published January 24, 1996, assigned to the assignee of the present invention and incorporated herein by reference.

Each terminal 2 has a contact portion 4 which is held upright within the connector housing 1 and generally against the sidewalls thereof. These contact portions 4 extend to about the bottom of the engagement slot 3 where they meet terminal connecting portions 6 which join the contact portions 4 to the solder tails 7. Inasmuch as the terminals 2 are typically produced by stamping and forming, the engagement arms 5, contact portions 4, connecting portions 6 and solder tails 7 are illustrated as integral with each other.

In an important aspect of the present invention and as shown best in FIG. 2, each terminal 2 is provided at its connecting portion 6 with surface interruptions or irregularities, such as the grooves 8 illustrated. These grooves 8 extend across the body of the connecting portion 6 in a direction transverse to the longitudinal extent of the contact portion 4, illustrated as generally perpendicular to the vertical axis **V** of the terminal contact portion 4. These grooves 8 are illustrated as being formed in three sides (or surfaces) 112-114 of the terminal 2. At least one of these surfaces is preferably the interior surface 114 of the terminal which is continuous with the surface of the contact portion 4 and a mounting surface of the solder tail 7. This surface lies generally opposite the solder tail 7.

When the electrical connector illustrated in FIGS. 1-3 is mounted on the printed circuit board 101 by way of surface mount soldering of the solder tails 7 to the circuit board traces 109 disposed thereon, contamination of the interior side surfaces 114 of the contact portion 4 by molten solder and/or solder flux is successfully avoided. This contamination occurs primarily due to "wicking" of molten solder and/or solder flux up through openings 106 in the housing floor 1b. This wicking occurs primarily through capillary action and sometimes the amount of solder or flux that wicks up from the solder tail 7 is large enough to deposit on the interior contact surfaces 114 of the terminals 2 which will lead to problems when a complementary plug connector is inserted into the female connector housing 1 illustrated. These deposits may cause poor contact quality between mating terminals.

This wicking is prevented by the structure of the present invention because the grooves 8 or other surface irregularities are formed in the terminal connecting portions 6 of the terminal 2 which is located within the bottom wall 1b of the connector housing 1. This interruption not only increases the distance which the molten solder and/or flux must travel to reach the contact portion 4, but also breaks the surface tension of the wicking material. Further, it defines a torturous path within and through each connector floor opening 106 which restricts the flow of molten solder and/or flux and substantially prevents the detrimental wicking described above from occurring.

The anti-wicking action of the connector is further enhanced during the housing molding process by forming a complementary shaped irregularity in the wall of the opening 106 of the housing floor 1b. This housing irregularity is illustrated as a protruding ridge 9 which engages the terminal grooves 8. As such, only a fine gap may exist with the inner periphery of the terminal groove 8 if any shrinkage occurs during the solidification of the housing material during the molding process. Molten solder or flux may accumulate in this gap to further restrict flow thereof to the contact piece 4.

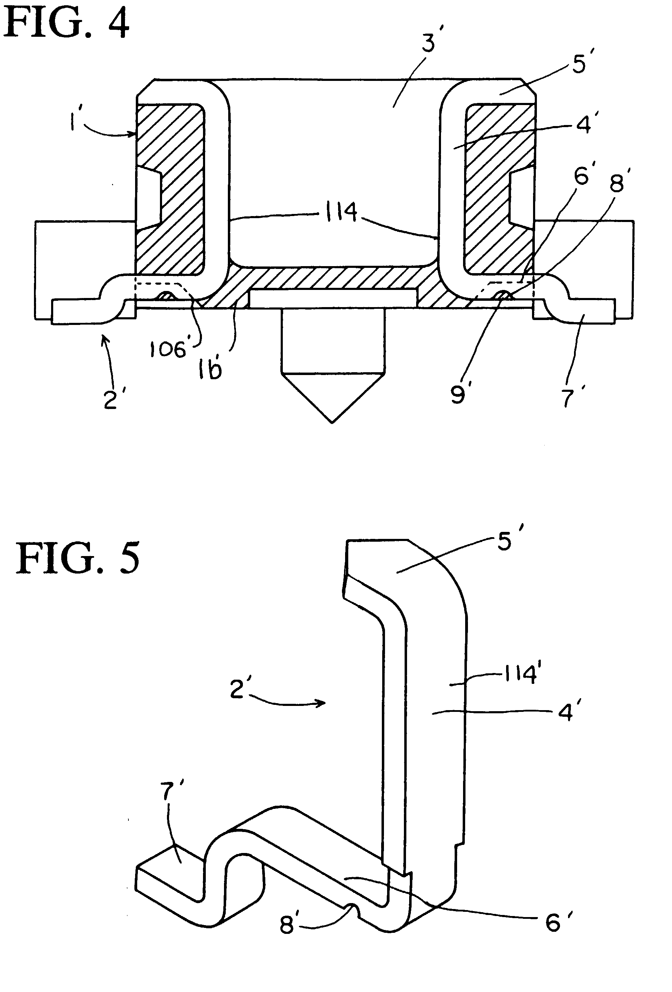

FIGS. 4 and 5 illustrate another embodiment of a connector constructed in accordance with the principles of the present invention. As with the first embodiment, the connector is produced with an insulative housing 1' and a plurality of terminals 2' by way of insert molding. The terminals 2' are each formed with an engagement arm 5' at the upper portion of the contact portion 4' and a solder tail 7' extending from the lower end thereof via a connecting portion 6'. As seen in the lower corners of FIG. 4, these connecting portions 6' lie within the bottom wall 1b' of the housing 1'. One surface of the connecting portions 6', which lies within the bottom wall 1b' of the housing 1' and on the same continuous surface as that of the interior surface 114' of the contact portion 4', has a groove or ridge 8' formed therein. This groove 8' functions in the same manner as the first embodiment disclosed above - it presents a surface interruption to break the surface tension of any material wicking up the terminal together with presenting a tortuous path to molten solder and/or flux as well as an obstacle on the surface of the terminal between the circuit trace 101' and the terminal contact portion 4'. The connector housing 1' may also contain a protrusion ridge 9' preferably complementary in shape to the groove 8'. This surface interruption 8' is disposed on a lateral surface of the terminal 2' which lies generally horizontal and at an angle to the contact portion 4' thereof at the level of the connector housing openings 106'. In some applications, the housing will not be insert molded around the groove 8'.

As set forth above, because the connectors of the present invention are successful in avoiding contamination of the terminal contact portions by molten solder and/or solder flux during the soldering thereof to circuit boards, high reliability in electrical connection with such a board to board connector can be achieved.

Although the invention has been illustrated and described with respect to exemplary embodiment thereof, it should be understood by those skilled in the art that the foregoing and various other changes, omissions and additions may be made therein and thereto, without departing from the spirit and scope of the present invention. Therefore, the present invention should not be understood as limited to the specific embodiments set forth above. For example, the configuration of the surfaces in which the surface interruptions 8, 8' are formed are not specific to only the configurations illustrated. While the illustrated embodiments are provided with grooves 8, 8' on one or three surfaces, it will be understood that the grooves may be formed over the entire periphery of the connecting portion or on two surfaces thereat, provided, however, that care is taken to prevent movement of the engagement arms 5, 5' of the terminals prior to insert molding of the housing. In any such instance, an equivalent contamination prevention can be expected as long as the recessed groove is formed on at least the surface continuous to an inner portion of the connector to which the contact portions of the counterpart opposing plug connectors will engage. In short, by providing a surface interruption or other type of unevenness, such as ridge or recess, at the terminal portion which extends through the insulative housing, the flow of the molten solder and flux can be restricted so as not to wick up to the contact portion of the terminal for assuring electrical connection with the counterpart plug connector.

It will be appreciated that the embodiments of the present invention discussed herein are merely illustrative of a few applications of the principles of the invention. Numerous modifications may be made by those skilled in the art without departing from the true spirit and scope of the invention.

## Claims

1. An electrical connector (100) comprising: a plurality of terminals (2) arranged in a predetermined pitch along the length of the connector (100), the terminals (2) being mounted within an insulative housing (1) of the connector (100), each of the terminals (2) having a contact portion (4) and a solder tail portion (7) extending from said connector housing (1) in a predetermined orientation for interconnection with a circuit trace (109) of a circuit member, said terminal contact and solder tail portions (4,7) being joined together by a terminal connecting portion (6), each of said terminals (2) having a surface interruption (8) formed across their respective connecting portions (6) between said contact and solder tail portions (4,7) thereof, said surface interruption defining a tortuous path along said connecting portion which inhibits the wicking of molten solder and solder flux up along said connecting portions (6) onto said terminal contact portions (4) during soldering of said connector (100) to said circuit board (101).

2. The connector as defined in claim 1, wherein said surface interruption is positioned within a portion of said housing.

3. The connector as defined in any preceding claim, wherein said surface interruption includes at least one groove (8, 8') formed across a surface (112,113,114) of said terminal (2) within said connecting portion (6) and said housing portion includes a projection (9) extending into said at least one groove and substantially closing said groove.

4. The connector as defined in any preceding claim, wherein said solder tail portion (7) has a mounting surface which opposes said circuit board (101) when said connector (100) is mounted thereto, and said surface interruption (8,8') is formed across a surface (114, 114') of said terminal (2) which is continuous with said solder tail portion mounting surface.

5. The connector as defined in any preceding claim, wherein said terminal connecting portion (6) is generally rectangular in cross-sectional configuration and includes four distinct side surfaces, said surface interruption being disposed across at least one (112,113,114) of said four distinct side surfaces.

6. The connector as defined in claim 5, wherein said surface interruption (8,8') is disposed across at least three (112, 113, 114) of said four distinct side surfaces.

7. The connector as defined in claim 6, wherein said connector housing (1) has a series of passages (106) extending through said housing portion, each passage (106) receiving said connecting portion (6) of a single terminal (2) therethrough, and wherein said terminal surface interruptions (8) are disposed across said connecting portions (6) at the level of said connector housing passages (106).

8. The connector as defined in any preceding claim, wherein each of said terminals (2) includes two opposing ends, one end being an engagement end (5) which engages said connector housing (1) and the other opposing end being said solder tail portion (7).

9. The connector as defined in any preceding claim, wherein said connector housing (1) has a plurality of passages (106) extending through a floor (1b) of said connector (100), said terminals (2) being held in said connector (100) by their connecting portions (6) passing through said passages (106), said terminal surface interruptions (8) being disposed across said connecting portions (6) and further being disposed within said connector housing passages (160).

10. The connector as defined in claim 9, wherein said connector housing includes a series of protrusions (9) disposed adjacent said connector housing passages (106), said protrusions (9) being complementary in shape to said terminal surface interruptions (8), said terminal surface interruptions (8) and connector housing protrusions (9) engaging each other to substantially close said surface interruptions.

11. The connector as defined in any preceding claim, wherein said surface interruption (8) is formed across an upright surface of said terminal connecting portion (6).

12. The connector as defined in any preceding claim, wherein said terminals are generally U-shaped, with first and second generally parallel legs (5,7) interconnected by a bight portion (4), said surface interruption (8) being formed across said bight portion.

13. The connector as defined in claim 12, wherein said first leg is generally positioned within said connector housing and a substantial portion of said second leg is positioned outside of said housing to act as a solder tail, said second leg being longer than said first leg.

14. The connector as defined in any preceding claim, wherein said housing includes an elongated connector component engagement slot (3) and said contact portions of said terminals extend into said slot.

15. The connector as defined in any preceding claim, wherein said terminal contact, solder tail and connecting portions (4,6,7) all share a common, continuous surface (114) and said surface interruption (8) is disposed on said common surface (114).

16. The connector as defined in claim 15, wherein said surface interruption (8) is a groove formed across said common surface (114).

17. The connector as defined in claim 1 wherein each of the terminals (2') has a generally U-shaped portion and a generally L-shaped portion extending from one end of said generally U-shaped portion, said generally U-shaped portion including first and second spaced apart, generally parallel legs (5', 6') and a bight portion (4') therebetween, said bight portion including the contact portion of said terminal, said surface interruption (8') being formed on said second leg (6') of said generally U-shaped portion.

18. The connector as defined in claim 17 wherein one leg of said generally L-shaped portion includes said solder tail portion (7').

19. The connector as defined in claim 18, wherein a portion of at least one of said second leg (6') and said bight portion (5') is embedded within said housing.

20. A method of manufacturing an electrical connector (100) having a plurality of terminals (2) arranged in a predetermined pitch along the length of the connector (100), said method comprising the steps of:
providing a plurality of terminals mounted to a carrier strip, each of the terminals (2) having a contact portion (4) and a solder tail portion (7), said contact and solder tail portions (4,7) being joined together by a terminal connecting portion (6), each of said terminals (2) having a surface interruption (8) formed across their respective connecting portions (6) between said contact and solder tail portions (4,7) thereof, said surface interruption defining a tortuous path along said connecting portion which inhibits the wicking of molten solder and solder flux up along said connecting portions (6) onto said terminal contact portions (4) during soldering of said connector (100) to a circuit board (101);
positioning said plurality of terminals within a mold having a cavity formed therein;
injecting plastic within said mold about said terminals to form a connector assembly, said connector assembly including a projection extending into each said surface interruption of said terminals to substantially close said groove;
removing said connector assembly from said mold; and
removing said carrier strip from said terminals.
